(19) 

Europäisches
Patentamt
European
Patent Office
Office européen
des brevets

(11) **EP 2 692 523 A1**

(12) **EUROPEAN PATENT APPLICATION**
published in accordance with Art. 153(4) EPC

(43) Date of publication:
**05.02.2014 Bulletin 2014/06**

(21) Application number: **12765371.5**

(22) Date of filing: **29.03.2012**

(51) Int Cl.:
***B32B 9/00*** *(2006.01)* ***C23C 14/34*** *(2006.01)*

(86) International application number:
**PCT/JP2012/058478**

(87) International publication number:
**WO 2012/133704 (04.10.2012 Gazette 2012/40)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **31.03.2011 JP 2011081284**

(71) Applicant: **Mitsubishi Plastics, Inc.
Tokyo 100-8252 (JP)**

(72) Inventors:
• **AMANAI, Hidetaka
Ushiku-shi
Ibaraki 300-1201 (JP)**
• **MIYAZAKI, Makoto
Ushiku-shi
Ibaraki 300-1201 (JP)**

(74) Representative: **HOFFMANN EITLE
Patent- und Rechtsanwälte
Arabellastrasse 4
81925 München (DE)**

(54) **GAS BARRIER LAMINATE FILM, AND METHOD FOR PRODUCING SAME**

(57) The present invention provides a gas barrier laminate film containing a substrate film having on at least one surface thereof plural layers of an inorganic thin film layer, from a first layer to an n-th layer (wherein n represents an integer of 1 or more) of the inorganic thin film layer on a side of the substrate film being formed by a non-plasma film forming method, and an (n+1)-th layer formed thereon in contact therewith being formed by a facing target sputtering method, and a method for producing a gas barrier laminate film containing a substrate film having on at least one surface thereof one or plural layers of an inorganic thin film layer, the method containing: forming from a first layer to an n-th layer of the inorganic thin film layer on a side of the substrate film by a non-plasma film forming method; and forming an (n+1)-th layer thereon in contact therewith by a facing target sputtering method, and thus provides a gas barrier laminate film with high gas barrier property and excellent productivity having a dense inorganic thin film layer that inflicts less damage to a substrate film, particularly to a resin film, on which the inorganic thin film layer is formed, and a method for producing the same.

**Description**

Technical Field

The present invention relates to a gas barrier laminate film, which is used as a package for preventing denaturation of foods, industrial articles, medical drugs and the like, a liquid crystal display device, an inorganic solar cell, an electromagnetic wave shield, a touch-sensitive panel, a color filter, a vacuum heat insulator, and an organic device, such as an organic EL (electroluminescence) device, an organic solar cell and an organic TFT, and a method for producing the same.

Background Art

A gas barrier plastic film containing a plastic film as a substrate having formed on the surface thereof an inorganic thin film is widely used as a package for an article that is necessarily shielded from various types of gas, such as water vapor and oxygen, for example, as a package for preventing denaturation of foods, industrial articles, medical drugs and the like. For the gas barrier plastic film, in recent years, new applications are receiving attention, in addition to the package, for example, a liquid crystal display device, an inorganic solar cell, an electromagnetic wave shield, a touch-sensitive panel, a color filter, a vacuum heat insulator, and a transparent electroconductive sheet and a vacuum heat insulator used in an organic device, such as an organic EL device, an organic solar cell and an organic TFT.

In these fields, such proposals have been made that a high-performance gas barrier film of an inorganic material is coated by a vacuum vapor deposition method, a magnetron sputtering method, an RF sputtering method, a plasma CVD method, an ion plating method or the like.

For further enhancing the gas barrier property, the use of a catalytic chemical vapor deposition (Cat-CVD) method has been known as a film forming method that inflicts less damage to a substrate film, as described, for example, in Patent Documents 1 and 2, but the sole use of the film forming method provides only a low film forming speed, and thus industrial productivity has not yet been established.

As another measure for enhancing the gas barrier property, it has been proposed that two or more layers of inorganic thin films are laminated on a substrate by repeating a vapor deposition process twice or more, thereby enhancing the gas barrier property of a plastic film, as described, for example, in Patent Document 3. However, the film forming method only provides a plastic film that is insufficient in gas barrier property, and if the gas barrier property is to be enhanced, the productivity is largely lowered in exchange therefor.

Related Art Documents

Patent Documents

Patent Document 1
JP-A-2004-217966
Patent Document 2
JP-A-2004-315899
Patent Document 3
JP-A-4-89236

Summary of the Invention

Problems to be solved by the Invention

An object of the present invention is to provide a gas barrier laminate film with high gas barrier property and excellent productivity having a dense inorganic thin film layer that inflicts less damage to a substrate film, particularly to a resin film, on which the inorganic thin film layer is formed, and a method for producing the same.

Means for solving the Problems

As a result of earnest investigations made by the present inventors, it has been found that the problems associated with the ordinary production methods are ascribable to the denseness of the film in the inorganic thin film layer and the damages on forming the film. Specifically, it has been found that in the case where the inorganic thin film layer is formed by a vacuum vapor deposition method, the substrate film may be prevented from receiving damages due to plasma, as being different from the ordinary sputtering method or the plasma film forming method, such as a plasma CVD method, described later, but the film generally has low denseness as compared to the sputtering method and the CVD method, and is insufficient in film quality for exhibiting gas barrier property. In a Cat-CVD method, which is a non-plasma film forming method as similar to a vacuum vapor deposition method, the substrate film may be prevented from receiving damages by plasma, and a film having high denseness may be obtained in the Cat-CVD method, but the Cat-CVD method has a low film forming speed, and the productivity is largely lowered when a sufficient film thickness for exhibiting barrier property is to be obtained. In the case where the film is formed by an ordinary sputtering method, such as a magnetron sputtering method and an RF sputtering method, or by a plasma film forming method, such as a plasma CVD method, although the film has high denseness, the substrate film is exposed directly to plasma, and thereby the barrier capability is deteriorated due to damages on the substrate film caused by the plasma. It is possible to lower the discharge electric power for film formation to reduce the damages by the plasma, but in this case, the film forming speed is considerably lowered, which causes a serious problem in productivity. In the case where the film is formed by an ion plating method, damages by plasma and damages by heat radiation may be suppressed to a certain degree by selecting the excitation source, but the substrate film is damaged by ions, electrons and X-ray subsidiarily formed by exciting the target, thereby deteriorating the barrier property.

It has been proposed to laminate two or more layers of inorganic thin films on a substrate by repeating the film forming method twice or more, thereby improving the gas barrier property of the plastic film, but the substrate film is exposed directly to plasma in the case where the first layer of the inorganic thin film layer formed on the substrate film is formed by an ordinary sputtering method, such as a magnetron sputtering method and an RF sputtering method, or a plasma film forming method, such as a plasma CVD method, as described above, and the barrier property is deteriorated due to the damages on the substrate film by the plasma. On the other hand, such a case has been investigated that the first layer of the inorganic thin film layer formed on the substrate film is formed as an underlayer by a vacuum vapor deposition method or a Cat-CVD method, and then the laminate film is formed by the plasma film forming method described above, but it has been found that the underlayer formed by the non-plasma film forming method receives damages by the plasma used in the plasma film forming method, as similar to the substrate film, and thus the barrier property is deteriorated. The damages by the plasma on lamination may be reduced by forming the film with reduced discharge power, but the film forming speed and the productivity are largely lowered in exchange therefor.

As a result of investigations for solving the problems, it has been found that a gas barrier laminate film containing a substrate having laminated thereon two or more layers of inorganic thin films that is excellent in gas barrier property and is excellent in productivity may be obtained by forming from a first layer to an n-th layer of the inorganic thin film layer on a side of the substrate film by a non-plasma film forming method, and forming an (n+1)-th layer in contact therewith by a facing target sputtering method.

Accordingly, the present invention provides a gas barrier laminate film containing a substrate film having on at least one surface thereof plural layers of an inorganic thin film layer, from a first layer to an n-th layer (wherein n represents an integer of 1 or more) of the inorganic thin film layer on a side of the substrate film being formed by a non-plasma film forming method, and an (n+1)-th layer formed thereon in contact therewith being formed by a facing target sputtering method, and a method for producing a gas barrier laminate film containing a substrate film having on at least one surface thereof one or plural layers of an inorganic thin film layer, the method containing: forming from a first layer to an n-th layer of the inorganic thin film layer on a side of the substrate film by a non-plasma film forming method; and forming an (n+1)-th layer thereon in contact therewith by a facing target sputtering method.

Advantages of the Invention

In the facing target sputtering method (which is hereinafter referred to as an FTS method), the plasma is confined in the region between the targets, and thus the film forming surface is not exposed directly to the plasma and secondary electrons. As a result, the film may be formed with less damage, and furthermore, a dense thin film may be formed as similar to the ordinary sputtering method.

On the substrate film, which may receive the largest damage by plasma, a film is formed by a non-plasma film forming method to form an underlayer as a protective film, and on forming a film on the underlayer, the inorganic thin film layer may be formed with a large film forming speed since the damages by plasma caused by the FTS method are significantly small, and the discharge power may not be necessarily lowered for reducing the damages by plasma, thereby providing high productivity.

Accordingly, the gas barrier laminate film of the present invention suffers less damage on the resin film and the interface between the inorganic thin film layers, thereby providing high gas barrier property and high productivity.

Brief Description of the Drawing

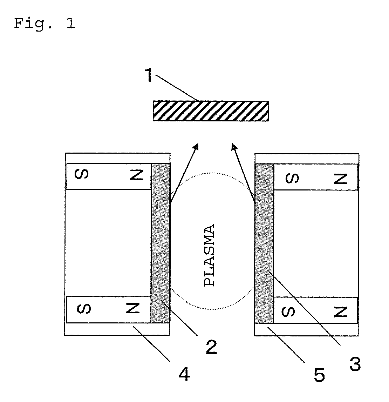

Fig. 1 is a schematic illustration showing an apparatus used for a facing target sputtering method.

Embodiments for carrying out the Invention

The present invention will be described in detail below.

Gas Barrier Laminate Film

The gas barrier laminate film of the present invention comprises a substrate film having on at least one surface thereof plural layers of an inorganic thin film layer, from the first layer to the n-th layer (wherein n represents an integer of 1 or more) of the inorganic thin film layer on the side of the substrate film is formed by a non-plasma film forming method, and the (n+1)-th layer formed thereon in contact therewith is formed by a facing target sputtering method.

Substrate Film

The substrate film of the gas barrier laminate film of the present invention is preferably a transparent polymer film, and a thermoplastic polymer film is more preferred in this point of view. The raw material used therefor may be any resin that can be used for an ordinary packaging material without particular limitation. Specific examples thereof include a polyolefin, such as a homopolymer or a copolymer of ethylene, propylene, butene and the like; an amorphous polyolefin, such as a cyclic polyolefin; a polyester, such as polyethylene terephthalate and polyethylene 2,6-naphthalate; a polyamide, such as nylon 6, nylon 66, nylon 12 and copolymer nylon; a polyvinyl alcohol, an ethylene-vinyl acetate copolymer partial hydrolysate (EVOH), a polyimide, a polyetherimide, a polysulfone, a polyethersulfone, a polyether ether ketone, a polycarbonate, a polyvinyl butyral, a polyarylate, a fluorine resin, an acrylate resin and a biodegradable resin. Among these, a polyester, a polyamide, a polyolefin and a biodegradable resin are preferred from the standpoint of the film strength, the cost and the like.

The substrate film may contain known additives, such as an antistatic agent, a light shielding agent, an ultraviolet ray absorbent, a plasticizer, a lubricant, a filler, a colorant, a stabilizer, a lubricating agent, a crosslinking agent, an antiblocking agent and an antioxidant.

The thermoplastic polymer film as the substrate film is molded by using the aforementioned raw material, and the film may be unstretched or stretched on being used as the substrate. The thermoplastic polymer film may also be laminated with another plastic substrate. The substrate film may be produced by a known method, and for example, a raw material resin is melted in an extruder and extruded through a circular die or a T-die, and then quenched, thereby producing an unstretched film, which is substantially amorphous and unoriented. The unstretched film is then stretched in the machine direction (longitudinal direction) of the film or in the machine direction (transverse direction) of the film and the direction perpendicular thereto by a known method, such as uniaxial stretching, tenter sequential biaxial stretching, tenter simultaneous biaxial stretching, and tubular simultaneous biaxial stretching, thereby producing a film having been stretched in at least one direction.

The thickness of the substrate film may be generally selected from a range of from 5 to 500 $\mu$m, and preferably from 10 to 200 $\mu$m, depending on the application thereof in consideration of the mechanical strength, the flexibility, the transparency and the like as the substrate of the gas barrier laminate film of the present invention, and a sheet material having a large thickness is also included. The width and length of the film are not particularly limited, and may be appropriately selected depending on the application thereof.

Inorganic Thin Film Layer

Examples of the inorganic substance that constitutes the inorganic thin film layer include compounds containing a typical metal or a 3d transition metal with oxygen, nitrogen or carbon, for example, silicon, aluminum, magnesium, zinc, tin, nickel, titanium, indium, gallium and the like, or oxides, carbides and nitrides thereof and mixtures thereof. From the standpoint of maintenance of high gas barrier property stably, preferred examples thereof include compounds containing a typical metal or a 3d transition metal with oxygen and/or nitrogen, and more preferred examples thereof include silicon compounds containing oxygen and/or nitrogen, and aluminum oxide. Among these, silicon oxide, silicon nitride and aluminum oxide are particularly preferred. In addition to the inorganic substances, a carbonaceous substance, such as diamond-like carbon, may also be used.

The material for constituting the (n+1)-th layer (which may be hereinafter referred to as an "intermediate layer") formed on the first layer to the n-th layer (which each may be hereinafter referred to as an "underlayer") may be, for example, a compound containing a typical metal or a 3d transition metal with oxygen and/or nitrogen, more preferably a silicon compound containing oxygen and nitrogen ($SiO_xN_y$) or aluminum oxide ($AlO_z$), and particularly preferably aluminum oxide ($AlO_z$), from the standpoint of the gas barrier property and the adhesion to the substrate film.

Herein, numerals x and y satisfy $0 \leq x \leq 2.0$, $0 \leq y \leq 1.3$ and $0 \leq x/2.0 + y/1.3 \leq 1$, and y is preferably from 0.1 to 1.3, and more preferably from 0.5 to 1.1. Numeral z satisfies $0 \leq z \leq 1.5$ and is preferably from 1 to 1.5, and more preferably 1.2 to 1.5.

The numeral n has no upper limit, and is generally from 1 to 3, preferably from 1 to 2 from the standpoint of the productivity, and is more preferably n = 1. The case where n is 1 means the underlayer has only the first layer.

The thickness of the inorganic thin film layer is generally from 5 to 1,000 nm, preferably from 10 to 500 nm, more preferably from 10 to 300 nm, and most preferably from 10 to 150 nm.

The thickness of the underlayer is generally from 0.1 to 500 nm, preferably from 0.5 to 200 nm, more preferably from 1 to 100 nm, and most preferably from 1 to 50 nm.

The thickness of the intermediate layer is generally from 0.1 to 500 nm, and since higher gas barrier property may be obtained with a smaller thickness, the thickness is preferably from 0.1 to 200 nm, more preferably from 0.1 to 100 nm, particularly preferably from 0.1 to 50 nm, and most preferably from 0.1 to 25 nm.

In the present invention, an inorganic thin film layer as the (n+2)-th or upper layers may be formed on the intermediate layer. The thickness of the inorganic thin film layer as the (n+2)-th or upper layers is generally from 5 to 1,000 nm, preferably from 10 to 500 nm, more preferably from 10 to 300 nm, and most preferably from 10 to 150 nm.

When the thickness is in the range, sufficient gas barrier property may be obtained, cracks and delamination may not occur in the thin film, and excellent transparency may be obtained.

Film Forming Method

In the present invention, the underlayer of the inorganic thin film layer is formed by a non-plasma film forming method for preventing the substrate film from receiving damages by plasma.

The non-plasma film forming method is not particularly limited as far as the film forming method does not use plasma, and for preventing the substrate film from receiving damages, such a film forming method is preferred that does not require a thermal decomposition process of the raw material of the inorganic thin film to be formed, such as a vacuum vapor deposition method and a catalytic chemical vapor deposition method (Cat-CVD method), and the vacuum vapor deposition method is particularly preferably a vacuum heating vapor deposition method.

The vacuum vapor deposition method is preferred due to the large film forming speed, and the Cat-CVD method is preferred due to a film having high denseness obtained thereby.

The Cat-CVD method may be performed with a catalytic chemical vapor deposition apparatus, in which a metal catalyst wire as a heating catalyst is heated in vacuum, and a material gas is subjected to catalytic decomposition by being brought into in contact with the metal catalyst wire, thereby forming a thin film containing the elements constituting the raw material gas as the major skeleton substance on a substrate film.

In the present invention, the method of forming the layer as the (n+2)-th or upper layers is not particularly limited, examples of which include a chemical vapor deposition method and a physical vapor deposition method. For example, the layer may be formed by various methods including a vacuum vapor deposition method, a magnetron sputtering method, an RF sputtering method, a plasma CVD method, an ion plating method, a facing target sputtering method and a catalytic chemical vapor deposition method.

The intermediate layer that is formed by the FTS method has high denseness and may be formed to have a large thickness due to the large film forming speed thereof, and thus is not damaged greatly by the film forming method for forming a film on the intermediate layer. However, for preventing the formed intermediate layer or the other inorganic thin film layers from receiving damages by plasma, such a layer is preferably formed thereon that is formed by a non-plasma film forming method, such as a vacuum vapor deposition method and a catalytic chemical vapor deposition method. Furthermore, a layer that is formed by a vacuum vapor deposition method is preferably formed from the standpoint of the productivity since a large film forming speed may be obtained to form an inorganic thin film layer having a sufficient thickness within a short period of time. The vacuum vapor deposition method is particularly preferably a vacuum heating vapor deposition method.

The layer as the (n+2)-th or upper layers formed by a vacuum vapor deposition method or a catalytic chemical vapor deposition method is preferably a layer formed of a silicon compound containing oxygen and/or nitrogen, and particularly preferably a layer formed of silicon oxide, from the standpoint of the durability, such as the heat and humidity resistance and the corrosion resistance.

The layer formed as the (n+2)-th or upper inorganic thin film layers by a vacuum vapor deposition method or a catalytic chemical vapor deposition method is preferably the uppermost layer most remote from the substrate among the continuous plural layers constituting the inorganic thin film layer since the aforementioned advantages may be most highly obtained. The uppermost layer most remote from the substrate in the case, for example, of the layer as the (n+2)-th or upper inorganic thin film layers having a constitution of (inorganic plural layers 1) / (organic layer) / (inorganic plural layers 2) means the upper most layers of each of the inorganic plural layers 1 and the inorganic plural layers 2.

It is preferred in the present invention that the inorganic thin film layer is formed continuously in an inert gas atmosphere or in vacuum without exposure to the air, and thereby the gas barrier property may be enhanced as compared to the case where the layers are formed discontinuously. It is considered that this is because excessive oxidation or inactivation of the surface due to the components of the air may not occur.

In the present invention, the intermediate layer of the inorganic thin film layer is formed by a facing target sputtering method (FTS method), which does not inflict damages to the underlayer and is capable of forming an inorganic thin film layer having high denseness at a high speed, thereby enhancing the barrier property.

The FTS method forms a film by using an apparatus having a sputtering target and a film forming substrate that are disposed perpendicularly (see, for example, JP-A-2007-23304, paragraphs (0051) to (0053) and Fig. 3), and as shown in Fig. 1, targets 2 and 3 are made to face each other in an apparatus, to which a gas is charged, and a magnetic field is formed with an electrode (anode) 4 and an electrode (cathode) 5, thereby forming a plasma atmosphere (which is surrounded by the broken line). The targets are sputtered in the atmosphere, and thereby the inorganic material thus flown is deposited on the surface of the substrate film 1 to form the inorganic thin film layer.

In the FTS method, the plasma is confined in the region between the targets, and thus the substrate is not exposed directly to the plasma or secondary electrons. As a result, the film may be formed with less damage, and furthermore, a dense thin film may be formed as similar to the ordinary sputtering method. The use of the FTS method realizes the formation of a dense inorganic thin film layer with suppressed damage on the substrate film, on which the inorganic thin film layer is formed, and thus is suitable as a thin film forming method for a barrier film.

The conditions of the FTS method employed in the present invention may be appropriately selected depending on the situation, and it is preferred that the film forming pressure is from 0.1 to 1 Pa, the electric power is from 0.5 to 10 kW, the frequency is from 1 to 1,000 kHz, and the pulse width is preferably from 1 to 1,000 $\mu$sec. When the conditions are in the ranges, the barrier film thus formed may have sufficient gas barrier property, cracks and delamination may not occur in the thin film, and excellent transparency may be obtained.

The introduced gas, such as Ar, $N_2$ and $O_2$, may be controlled for the introducing rates by the film forming pressure, and the flow ratio of Ar, $N_2$ and $O_2$ may be controlled to provide the desired composition for the layer to be formed.

Anchor Coating Layer

In the present invention, an anchor coating layer is preferably provided by coating an anchor coating agent between the substrate film and the underlayer, for enhancing the adhesion between the substrate film and the inorganic thin film layer. Examples of the anchor coating agent in view of the productivity include a polyester resin, a urethane resin, an acrylic resin, a nitrocellulose resin, a silicone resin, a vinyl alcohol resin, a polyvinyl alcohol resin, an ethylene-vinyl alcohol resin, a modified vinyl resin, an isocyanate group-containing resin, a carbodiimide resin, an alkoxy group-containing resin, an epoxy resin, an oxazoline resin, a modified styrene resin, a modified silicone resin, an alkyl titanate resin and a poly-p-xylene resin, which may be used solely or as a combination of two or more kinds thereof.

The thickness of the anchor coating layer provided on the substrate film is generally from 0.1 to 5, 000 nm, preferably from 1 to 2,000 nm, and more preferably from 1 to 1,000 nm. When the thickness is in the range, good lubricating property may be obtained, delamination of the anchor coating layer from the substrate due to internal stress in the anchor coating layer may substantially not occur, a uniform thickness may be maintained, and excellent adhesion between the layers may be obtained.

For enhancing the coating property and the adhesion property of the anchor coating agent to the substrate film, the substrate film may be subjected to an ordinary surface treatment, such as a chemical treatment and a discharge treatment, before coating the anchor coating agent.

Constitution of Gas Barrier Laminate Film

The gas barrier laminate film of the present invention may preferably have the following embodiments of laminate constitution from the standpoint of the gas barrier property and the adhesion property.

(1) (substrate film) / (non-plasma inorganic thin film layer) / (FTS inorganic thin film layer)

(2) (substrate film) / (non-plasma inorganic thin film layer) / (FTS inorganic thin film layer) / (non-plasma inorganic thin film layer)

(3) (substrate film) / (non-plasma inorganic thin film layer) / (FTS inorganic thin film layer) / (FTS inorganic thin film layer)

(4) (substrate film) / (AC) / (non-plasma inorganic thin film layer) / (FTS inorganic thin film layer)

(5) (substrate film) / (AC) / (non-plasma inorganic thin film layer) / (FTS inorganic thin film layer) / (non-plasma inorganic thin film layer)

(6) (substrate film) / (AC) / (non-plasma inorganic thin film layer) / (FTS inorganic thin film layer) / (FTS inorganic thin film layer)

The (AC) means the anchor coating layer, the (FTS inorganic thin film layer) means the inorganic thin film layer formed by an FTS method, and the (non-plasma inorganic thin film layer) means the inorganic thin film layer formed by a non-plasma film forming method, preferably a vacuum vapor deposition method or a catalytic chemical vapor deposition method.

The gas barrier laminate film of the present invention thus obtained is excellent in gas barrier property, and thus may have a moisture permeability under conditions of 40°C and 90 RH% of 0.1 $g/m^2$/day or less, further 0.05 $g/m^2$/day or less, and still further 0.02 $g/m^2$/day or less.

As the gas barrier laminate film of the present invention is excellent in transparency without forming cracks and delamination occurring in the thin film, the gas barrier laminate film may be used in any application, for example, a package for preventing denaturation of foods, industrial articles, medical drugs and the like, a liquid crystal display device, an inorganic solar cell, an electromagnetic wave shield, a touch-sensitive panel, a color filter, a vacuum heat insulator, and an organic device, such as an organic EL device, an organic solar cell and an organic TFT, and may be particularly preferably used as a protective sheet for an electronic device, such as a liquid crystal display device, a solar cell, an organic device and a vacuum heat insulator.

Examples

The present invention will be described in more detail with reference to examples below, but the present invention is not limited to the examples. The gas barrier laminate films obtained in the examples were evaluated for capabilities in the following manners.

Water Vapor Permeability

The water vapor permeability was evaluated in the following manner according to the conditions of JIS Z0222, test method for moisture permeability for moisture proof packaging container, and JIS Z0208, test method for moisture permeability for moisture proof packaging material (cup method).

Two sheets of the gas barrier laminate films each having a moisture permeation area of a square of 10.0 cm $\times$ 10.0 cm were used, and a bag having been sealed on the four edges thereof containing approximately 20 g of anhydrous calcium chloride as a desiccant was produced therewith. After placing the bag in a constant temperature and humidity chamber at a temperature of 40°C and a relative humidity of 90%, the mass thereof was measured (by 0.1 mg) with an interval of 48 hours or more for 34.8 days, which was an expected period when the weight increment became constant, and the water vapor permeability was calculated from the following expression.

$$\texttt{water vapor permeability } (\texttt{g/m}^2\texttt{/day}) = (\texttt{m/s})\texttt{/t}$$

m: mass increment between the last two weight measurements in the test period (g)
s: moisture permeation area ($m^2$)
t: period of time between the last two weight measurements in the test period (day) / 6.8 (day)

Control of Thickness of Inorganic Thin Film Layer formed by FTS Method

For the thickness of the inorganic thin film, single layer thin films formed under various conditions in advance were measured with a step gauge, and the film forming speeds under the conditions were calculated from the film forming time and the thickness. Thereafter, the film was formed while controlling the film forming time based on the film forming speed under the film forming condition, thereby controlling the thickness of the inorganic thin film layer.

Measurement of Thickness of Inorganic Thin Film Layer formed by PVD Method

The thickness of the inorganic thin film was measured with a fluorescent X-ray. This method utilizes the phenomenon that an atom irradiated with an X-ray radiates a fluorescent X-ray that is characteristic of the atom, and the number of atoms (i.e., the amount thereof) may be obtained by measuring the intensity of the fluorescent X-ray radiated. Specifically, thin films with two known thicknesses were formed on a film and measured respectively for the intensity of the characteristic fluorescent X-ray thus radiated, and a calibration curve was produced from the resulting information.

A specimen to be measured was then measured similarly for the intensity of the fluorescent X-ray, and the thickness thereof was measured from the calibration curve.

In the following description, the layer, such as the intermediate layer, may be referred to as a film, such as an $SiO_xN_y$ film, in some cases.

Example 1

A polyethylene naphthalate film having a thickness of 12 $\mu$m (Q51C, produced by Teijin DuPont Films Japan Ltd.) was used as the substrate film, and on a corona treated surface thereof, a mixture obtained by mixing an isocyanate compound (Coronate L, produced by Nippon Polyurethane Industry Co., Ltd.) and a saturated polyester (Vylon 300, produced by Toyobo Co., Ltd. , number average molecular weight: 23, 000) at a mass ratio of 1 : 1 was coated and dried to form an anchor coating layer having a thickness of 0.1 $\mu$m. On the anchor coating layer, furthermore, SiO was evaporated in vacuum of $2 \times 10^{-3}$ Pa with a vacuum vapor deposition apparatus, thereby forming a vacuum vapor deposition film (PVD film) of $SiO_x$ having a thickness of 32 nm.

Subsequently, an $SiO_xN_y$ film having a thickness of 50 nm was formed on the PVD film by an FTS method under conditions of a film forming pressure of 0.5 Pa and an electric power of 4, 000 W, thereby providing a laminate film. The laminate film thus obtained was evaluated in the aforementioned manners. The results obtained are shown in Table 1.

The evaluation of the composition of the resulting $SiO_xN_y$ film by an XPS method revealed x = 0.18 and y = 0.83.

Example 2

A laminate film was obtained in the same manner as in Example 1 except that an $SiO_x$ PVD film having a thickness of 50 nm was formed as the uppermost layer on the $SiO_xN_y$ film with a vacuum vapor deposition apparatus by evaporating SiO in vacuum of $2 \times 10^{-3}$ Pa. The laminate film thus obtained was evaluated in the aforementioned manners. The results obtained are shown in Table 1.

Example 3

A laminate film was obtained in the same manner as in Example 2 except that the thickness of the PVD film formed on the $SiO_xN_y$ film was changed to 100 nm. The laminate film thus obtained was evaluated in the aforementioned manners. The results obtained are shown in Table 1.

Example 4

A laminate film was obtained in the same manner as in Example 1 except that the film forming conditions on forming the $SiO_xN_y$ film shown in Table 1 were used, for example, a film forming pressure of 0. 3 Pa and the gas flow rates shown in Table 1. The laminate film thus obtained was evaluated in the aforementioned manners. The results obtained are shown in Table 1.

Example 5

A laminate film was obtained in the same manner as in Example 2 except that the film forming conditions on forming the $SiO_xN_y$ film shown in Table 1 were used, for example, a film forming pressure of 0.3 Pa and the gas flow rates shown in Table 1. The laminate film thus obtained was evaluated in the aforementioned manners. The results obtained are shown in Table 1.

Example 6

A laminate film was obtained in the same manner as in Example 2 except that the film forming conditions on forming the $SiO_xN_y$ film shown in Table 1 were used, for example, a film forming pressure of 0.2 Pa and the gas flow rates shown in Table 1. The laminate film thus obtained was evaluated in the aforementioned manners. The results obtained are shown in Table 1.

Example 7

A laminate film was obtained in the same manner as in Example 1 except that the film forming conditions on forming the $SiO_xN_y$ film shown in Table 1 were used, for example, an electric power of 2, 000 W and the gas flow rates shown in Table 1. The laminate film thus obtained was evaluated in the aforementioned manners. The results obtained are shown in Table 1.

The evaluation of the composition of the resulting $SiO_xN_y$ film by an XPS method revealed x = 0.35 and y = 0.74.

Example 8

A laminate film was obtained in the same manner as in Example 2 except that the film forming conditions on forming the $SiO_xN_y$ film shown in Table 1 were used, for example, an electric power of 2, 000 W and the gas flow rates shown in Table 1. The laminate film thus obtained was evaluated in the aforementioned manners. The results obtained are shown in Table 1.

Example 9

A laminate film was obtained in the same manner as in Example 5 except that the film forming conditions on forming the $SiO_xN_y$ film shown in Table 1 were used, for example, an electric power of 2, 000 W and the gas flow rates shown in Table 1. The laminate film thus obtained was evaluated in the aforementioned manners. The results obtained are shown in Table 1.

The evaluation of the composition of the resulting $SiO_xN_y$ film by an XPS method revealed x = 0.30 and y = 0.61.

Example 10

A laminate film was obtained in the same manner as in Example 2 except that an SiN film having a thickness of 50 nm was formed by the FTS method under the conditions shown in Table 1 instead of the $SiO_xN_y$ film. The laminate film thus obtained was evaluated in the aforementioned manners. The results obtained are shown in Table 1.

Example 11

A laminate film was obtained in the same manner as in Example 1 except that the film forming conditions on forming the $SiO_xN_y$ film shown in Table 1 were used, for example, a film forming pressure of 0.3 Pa, an electric power of 1,000 W and the gas flow rates shown in Table 1. The laminate film thus obtained was evaluated in the aforementioned manners. The results obtained are shown in Table 1.

Example 12

A laminate film was obtained in the same manner as in Example 2 except that an $AlO_z$ film having a thickness of 50 nm was formed by the FTS method under the conditions shown in Table 1 instead of the $SiO_xN_y$ film. The laminate film thus obtained was evaluated in the aforementioned manners. The results obtained are shown in Table 1.

The evaluation of the composition of the resulting $AlO_z$ film by an XPS method revealed z = 1.21.

Example 13

A laminate film was obtained in the same manner as in Example 12 except that the film forming conditions on forming the $AlO_z$ film were changed to those shown in Table 1. The laminate film thus obtained was evaluated in the aforementioned manners. The results obtained are shown in Table 1.

The evaluation of the composition of the resulting $AlO_z$ film by an XPS method revealed z = 1.24.

Example 14

A laminate film was obtained in the same manner as in Example 13 except that the thickness of the $AlO_z$ film was changed to 25 nm. The laminate film thus obtained was evaluated in the aforementioned manners. The results obtained are shown in Table 1.

Example 15

A laminate film was obtained in the same manner as in Example 13 except that the thickness of the $AlO_z$ film was changed to 10 nm. The laminate film thus obtained was evaluated in the aforementioned manners. The results obtained are shown in Table 1.

Example 16

A laminate film was obtained in the same manner as in Example 12 except that the film forming conditions on forming the $AlO_z$ film shown in Table 1 were used, for example, a film forming pressure of 0.3 Pa, an electric power of 2,000 W and the gas flow rates shown in Table 1. The laminate film thus obtained was evaluated in the aforementioned manners. The results obtained are shown in Table 1.

Example 17

A laminate film was obtained in the same manner as in Example 12 except that an $SiO_x$ film formed on the anchor coating layer by a catalytic chemical vapor deposition (Cat-CVD) method under conditions of a film forming pressure of 100 Pa, an electric power fed to the catalyst of 1.8 kW, an HMDS flow rate of 10 sccm and an $H_2$ flow rate of 1,000 sccm, instead of the PVD film 1, and an $AlO_z$ film was formed thereon by the FTS method under the film forming conditions shown in Table 1. The  laminate film thus obtained was evaluated in the aforementioned manners. The results obtained are shown in Table 1.
The evaluation of the composition of the resulting $AlO_z$ film by an XPS method revealed z = 1.23.

Comparative Example 1

A laminate film was obtained in the same manner as in Example 1 except that the thickness of the $SiO_x$ layer (PVD 1) formed on the anchor coating layer with a vacuum vapor deposition apparatus was changed to 50 nm, the $SiO_xN_y$ film was not formed, the test period of the water vapor permeability measurement was changed to 43.7 days, and the period of time between the last two measurements in the test period was changed to 6.9 days. The laminate film thus obtained was evaluated in the aforementioned manners. The results obtained are shown in Table 1.

Comparative Example 2

A laminate film was obtained in the same manner as in Comparative Example 1 except that a PVD film 2 of $SiO_x$ having a thickness of 50 nm was formed as the uppermost layer on the PVD film 1 of $SiO_x$ having a thickness of 50 nm with a vacuum vapor deposition apparatus by evaporating SiO in vacuum of $2 \times 10^{-3}$ Pa, the test period of the water vapor permeability measurement was changed to 26.3 days, and the period of time  between the last two measurements in the test period was changed to 6.0 days. The laminate film thus obtained was evaluated in the aforementioned manners. The results obtained are shown in Table 1.

Comparative Example 3

A laminate film was obtained in the same manner as in Example 12 except that an $AlO_z$ film (ordinary sputtered film) having a thickness of 50 nm was formed instead of the PVD film 1 on the anchor coating layer by an ordinary parallel flat plate DC magnetron sputtering method with Al metal as a target under conditions of a film forming pressure of 0.3 Pa, an electric power of 300 W, no bias voltage applied, an Ar flow rate of 20 sccm and an $O_2$ flow rate of 10 sccm, and an $AlO_z$ film having a thickness of 50 nm was formed thereon by an FTS method under the film forming conditions shown in Table 1. The laminate film thus obtained was evaluated in the aforementioned manners. The results obtained are shown in Table 1.

Table 1

| | Layer constitution | Thickness | | | Conditions for formation of FTS film | | | | | | | | | | Water vapor permeability (g/m2/day) |
|---|---|---|---|---|---|---|---|---|---|---|---|---|---|---|---|
| | | PVD film 1 (nm) | FTS film 1 (nm) | PVD film 2 (nm) | Film forming pressure (Pa) | Electric power (W) | Voltage (V) | Current (A) | Frequency (kHz) | Pulse width ($\mu$sec) | Ar (sccm) | 02 (sccm) | N2 (sccm) | |
| Example 1 | PEN/AC/PVD1/SiOxNy | 32 | 50 | - | 0.5 | 4,000 | 390 | 10.2 | 100 | 4 | 67 | 2 | 25 | 0.016 |
| Example 2 | PEN/AC/PVD1/SiOxNy/PVD2 | 32 | 50 | 50 | do. | do. | do. | do. | do. | do. | do. | do. | do. | 0.013 |
| Example 3 | PEN/AC/PVD1/SiOxNy/PVD2 | 32 | 50 | 100 | do. | do. | do. | do. | do. | do. | do. | do. | do. | 0.012 |
| Example 4 | PEN/AC/PVD1/SiOxNy | 32 | 50 | - | 0.3 | do. | 442 | 9.0 | do. | do. | 36 | do. | 18 | 0.017 |
| Example 5 | PEN/AC/PVD1/SiOxNy/PVD2 | 32 | 50 | 50 | do. | do. | do. | do. | do. | do. | do. | do. | do. | 0.007 |
| Example 6 | PEN/AC/PVD1/SiOxNy/PVD2 | 32 | 50 | 50 | 0.2 | do. | 500 | 8.0 | do. | do. | 25 | do. | 14 | 0.009 |
| Example 7 | PEN/AC/PVD1/SiOxNy | 32 | 50 | - | 0.5 | 2,000 | 330 | 6.0 | do. | do. | 65 | do. | 20 | 0.015 |
| Example 8 | PEN/AC/PVD1/SiOxNy/PVD2 | 32 | 50 | 50 | do. | do. | do. | do. | do. | do. | do. | do. | do. | 0.013 |
| Example 9 | PEN/AC/PVD1/SiOxNy/PVD2 | 32 | 50 | 50 | 0.3 | do. | 343 | 5.8 | do. | do. | 36 | do. | 16 | 0.012 |
| Example 10 | PEN/AC/PVD1/SiN/PVD2 | 32 | 50 | 50 | do. | do. | do. | do. | do. | do. | 35 | - | 13 | 0.009 |
| Example 11 | PEN/AC/PVD1/SiOxNy/PVD2 | 32 | 50 | 50 | do. | 1,000 | 301 | 3.3 | do. | do. | 34 | do. | 15 | 0.010 |
| Example 12 | PEN/AC/PVD1/AlOz/PVD2 | 32 | 50 | 50 | 0.5 | 4,000 | 340 | 11.8 | 100 | 2 | 68 | 36 | - | 0.010 |
| Example 13 | PEN/AC/PVD1/AlOz/PVD2 | 32 | 50 | 50 | 0.3 | 2,000 | 318 | 6.3 | do. | do. | 40 | 20 | - | 0.006 |
| Example 14 | PEN/AC/PVD1/AlOz/PVD2 | 32 | 25 | 50 | do. | do. | do. | do. | do. | do. | do. | do. | - | 0.003 |
| Example 15 | PEN/AC/PVD1/AlOz/PVD2 | 32 | 10 | 50 | do. | do. | do. | do. | do. | do. | do. | do. | - | 0.002 |
| Example 16 | PEN/AC/PVD1/AlOz/PVD2 | 32 | 50 | - | 0.3 | 2,000 | 320 | 6.3 | do. | do. | 37 | 20 | - | 0.005 |
| Example 17 | PEN/AC/Cat-CVD/AlOz/PVD2 | 20 (Cat-CVD film) | 50 | 50 | 0.5 | 2,600 | 320 | 8.1 | do. | do. | 100 | 14 | - | 0.002 |
| Comparative Example 1 | PEN/AC/PVD1 | 50 | - | - | - | - | - | - | - | - | - | - | - | 0.467 |
| Comparative Example 2 | PEN/AC/PVD1/PVD2 | 50 | - | 50 | - | - | - | - | - | - | - | - | - | 0.382 |

(continued)

| Layer constitution | Thickness | | | Conditions for formation of FTS film | | | | | | | | | Water vapor permeability (g/m2/day) |
|---|---|---|---|---|---|---|---|---|---|---|---|---|---|
| | PVD film 1 (nm) | FTS film 1 (nm) | PVD film 2 (nm) | Film forming pressure (Pa) | Electric power (W) | Voltage (V) | Current (A) | Frequency (kHz) | Pulse width (μsec) | Ar (sccm) | O2 (sccm) | N2 (sccm) | |
| Comparative Example 3 PEN/AC/(ordinary sputtered film)/AlOz/PVD2 | 50 (ordinary sputtered film) | 50 | 30 | 0.5 | 2,600 | 320 | 8.1 | do. | do. | 100 | 14 | - | 0.097 |

Note:
PEN: polyethylene naphthalate
AC: anchor coating layer
Layer constitution: lower layer on left side, upper layer on right side
SiOxNy, AlOz and SiN: films formed by FTS method (except for Comparative Example 3)
PVD film: formed by vacuum vapor deposition method

It has been apparent from the above that the gas barrier laminate films of Examples 1 to 17 having the constitutions according to the present invention had excellent gas barrier property.

On the other hand, the gas barrier laminate films of Comparative Examples 1 and 2 having the inorganic thin film layer without the intermediate layer formed by the FTS method had insufficient gas barrier property. It is considered that this is because of the low denseness of the inorganic thin film layer comprising only the layers formed by the PVD method.

Furthermore, the gas barrier laminate film of Comparative Example 3 having the underlayer formed by the ordinary sputtering method, which is a plasma film forming method, also had insufficient gas barrier property. It is considered that this is because of the damages by plasma on the substrate film.

Industrial Applicability

The gas barrier laminate film of the present invention may be preferably applied to a package for preventing denaturation of foods, industrial articles, medical drugs and the like, a liquid crystal display device, a solar cell, an electromagnetic wave shield, a touch-sensitive panel, a color filter, a vacuum heat insulator, and a protective sheet for an organic device and the like, such as an organic EL device, an organic solar cell and an organic TFT.

Description of Symbols

1      substrate film
2, 3   target
4      electrode (anode)
5      electrode (cathode)

**Claims**

1. A gas barrier laminate film comprising a substrate film having on at least one surface thereof plural layers of an inorganic thin film layer, from a first layer to an n-th layer (wherein n represents an integer of 1 or more) of the inorganic thin film layer on a side of the substrate film being formed by a non-plasma film forming method, and an (n+1)-th layer formed thereon in contact therewith being formed by a facing target sputtering method.

2. The gas barrier laminate film according to claim 1, wherein the (n+1)-th layer of the inorganic thin film layer on a side of the substrate film is a layer containing a compound containing a typical metal or a 3d transition metal with oxygen and/or nitrogen.

3. The gas barrier laminate film according to claim 1, wherein the (n+1)-th layer of the inorganic thin film layer on a side of the substrate film is a layer containing a silicon compound containing oxygen and/or nitrogen, or aluminum oxide.

4. The gas barrier laminate film according to claim 1, which has an inorganic thin film layer as (n+2) -th or upper inorganic thin film layers on the (n+1) -th layer on a side of the substrate film.

5. The gas barrier laminate film according to any one of claims 1 to 4, wherein the non-plasma film forming method for forming from the first layer to the n-th layer of the inorganic thin film layer is a vacuum vapor deposition method or a catalytic chemical vapor deposition method.

6. The gas barrier laminate film according to claim 4, wherein the inorganic thin film layer as (n+2)-th or upper layers is formed by a vacuum vapor deposition method or a catalytic chemical vapor deposition method.

7. The gas barrier laminate film according to claim 5 or 6, wherein the inorganic thin film layer formed by a vacuum vapor deposition method or a catalytic chemical vapor deposition method is a layer containing a silicon compound containing oxygen and/or nitrogen.

8. The gas barrier laminate film according to claim 6, wherein the inorganic thin film layer formed by a vacuum vapor deposition method or a catalytic chemical vapor deposition method contained in the inorganic thin film layer as (n+2)-th or upper layers is the uppermost layer most remote from the  substrate among continuous plural layers constituting the inorganic thin film layer.

9. The gas barrier laminate film according to any one of claims 1 to 8, wherein the plural layers of the inorganic thin film layer are formed continuously in an inert gas atmosphere or in vacuum without exposure to the air.

10. The gas barrier laminate film according to any one of claims 1 to 9, wherein from the first layer to the n-th layer of the inorganic thin film layer each have a thickness of from 0.1 to 500 nm, and the (n+1)-th layer has a thickness of from 0.1 to 500 nm.

11. The gas barrier laminate film according to any one of claims 1 to 9, wherein the (n+1) -th layer of the inorganic thin film layer has a thickness of from 0.1 to 50 nm.

12. The gas barrier laminate film according to any one of claims 1 to 11, which has an anchor coating layer between the substrate film and the first layer of the inorganic thin film layer on a side of the substrate film.

13. A protective sheet for a solar cell, comprising the gas barrier laminate film according to any one of claims 1 to 12.

14. A protective sheet for a liquid crystal display device, comprising the gas barrier laminate film according to any one of claims 1 to 12.

15. A protective sheet for an organic device, comprising the gas barrier laminate film according to any one of claims 1 to 12.

16. A protective sheet for a vacuum heat insulator, comprising the gas barrier laminate film according to any one of claims 1 to 12.

17. A method for producing a gas barrier laminate film comprising a substrate film having on at least one surface thereof one or plural layers of an inorganic thin film layer, the method comprising: forming from a first layer to an n-th layer (wherein n represents an integer of 1 or more) of the inorganic thin film layer on a side of the substrate film by a non-plasma film forming method; and forming an (n+1) -th layer thereon in contact therewith by a facing target sputtering method.

18. The method for producing a gas barrier laminate film according to claim 17, which contains forming an inorganic thin  film layer as (n+2)-th or upper layers on the (n+1)-th layer.

19. The method for producing a gas barrier laminate film according to claim 17, wherein the gas barrier laminate film is one according to any one of claims 2, 3, 5, 7 and 9 to 12.

20. The method for producing a gas barrier laminate film according to claim 18, wherein the gas barrier laminate film is one according to claim 6 or 8.

Fig. 1

<table>
<tr><td colspan="3" align="center">**INTERNATIONAL SEARCH REPORT**</td><td>International application No.<br>PCT/JP2012/058478</td></tr>
</table>

| | |
|---|---|
| A. CLASSIFICATION OF SUBJECT MATTER | |
| *B32B9/00*(2006.01)i, *C23C14/34*(2006.01)i | |

According to International Patent Classification (IPC) or to both national classification and IPC

B. FIELDS SEARCHED

Minimum documentation searched (classification system followed by classification symbols)
B32B1/00-43/00, C08J7/04-7/06, C23C14/00-14/58

Documentation searched other than minimum documentation to the extent that such documents are included in the fields searched

| | | |
|---|---|---|
| Jitsuyo Shinan Koho | 1922-1996 | Jitsuyo Shinan Toroku Koho 1996-2012 |
| Kokai Jitsuyo Shinan Koho | 1971-2012 | Toroku Jitsuyo Shinan Koho 1994-2012 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2008-230098 A (Mitsubishi Plastics, Inc.),<br>02 October 2008 (02.10.2008),<br>claims 1, 2, 7; paragraphs [0001], [0015],<br>[0023]<br>(Family: none) | 1,3-20 |
| Y | JP 2000-6297 A (Dainippon Printing Co., Ltd.),<br>11 January 2000 (11.01.2000),<br>example 2; paragraph [0021]<br>(Family: none) | 1,2,5,9-11,<br>17,19 |
| Y | JP 6-238805 A (Japan Synthetic Rubber Co.,<br>Ltd.),<br>30 August 1994 (30.08.1994),<br>paragraphs [0014], [0017] to [0019]<br>(Family: none) | 1-20 |

[X] Further documents are listed in the continuation of Box C.     [ ] See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search<br>07 May, 2012 (07.05.12) | Date of mailing of the international search report<br>22 May, 2012 (22.05.12) |
|---|---|
| Name and mailing address of the ISA/<br>Japanese Patent Office | Authorized officer |
| Facsimile No. | Telephone No. |

Form PCT/ISA/210 (second sheet) (July 2009)

16

**INTERNATIONAL SEARCH REPORT**

International application No.

PCT/JP2012/058478

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 2001-335926 A  (The Nippon Synthetic Chemical Industry Co., Ltd.), 07 December 2001 (07.12.2001), paragraph [0004] (Family: none) | 1-20 |
| Y | JP 3-64449 A  (Reiko Co., Ltd), 19 March 1991 (19.03.1991), claim 2 (Family: none) | 4,6,8,18,20 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004217966 A
- JP 2004315899 A
- JP 4089236 A
- JP 2007023304 A